# EUROPEAN PATENT APPLICATION

(11) **EP 4 683 487 A1**
(43) Date of publication of application: **21.01.2026**
(21) Application number: 24784668.6
(22) Date of filing: 07.03.2024
(51) Int. Cl.: H10N 60/12, G01J 1/02, G01J 1/44, G01J 11/00

(54) **SIGNAL PROCESSING CIRCUIT AND SIGNAL PROCESSING METHOD**

(30) Priority: 07.04.2023 JP 2023062659
(71) Applicant: National Institute of Information and Communications Technology, Koganei-shi, Tokyo 184-8795 (JP)
(72) Inventor: CHINA, Fumihiro, Koganei-shi, Tokyo 184-8795 (JP); MIKI, Shigehito, Koganei-shi, Tokyo 184-8795 (JP); TERAI, Hirotaka, Koganei-shi, Tokyo 184-8795 (JP)
(74) Representative: Witte, Weller & Partner Patentanwälte mbB
(86) International application number: PCT/JP2024/008823
(87) International publication number: WO 2024/209873

(57) **Abstract**

A signal processing circuit includes: a first transmission line through which a pulse signal is transmitted; a SQUID including first and second magnetic field receivers that are magnetically coupled to the first transmission line in response to transmission of the pulse signal through the first transmission line; a second transmission line connected to a current source and the SQUID; and a delay circuit disposed in the first transmission line to delay the pulse signal, the delay circuit being located between a part of the first transmission line that is magnetically coupled to the first magnetic field receiver and a part of the first transmission line that is magnetically coupled to the second magnetic field receiver. The delay time set for the pulse signal by the delay circuit is shorter than the sum of the rise time and the fall time of the pulse signal. A magnetic field input to the first magnetic field receiver and a magnetic field input to the second magnetic field receiver are oriented in opposite directions such that a voltage signal transmitted through the second transmission line has a pulse width equal to the delay time.

## Description

### Technical Field

The present disclosure relates to a signal processing circuit and a signal processing method.

### Background Art

Superconducting nanostrip single-photon detectors (hereinafter "SNSPDs") offer performance advantages such as high detection efficiency, high temporal resolution (timing jitter), and low dark count rate over conventional single-photon detectors (such as avalanche photodiode detectors), and are therefore promising for use in a wide range of fields such as quantum communication.

SNSPDs are required to operate in refrigerators at around 2.3 Kelvin (K). For a multi-pixel SNSPD array including light receivers of many SNSPDs to operate in a refrigerator, an increased number of transmission cables are needed to read out pulse signals output from the SNSPDs. This could cause penetration of external heat through the cables, making it difficult to allow the multi-pixel SNSPD array to operate at extremely low temperatures. Accordingly, realization of a multichannel SNSPD system requires a design that can multiplex signals from SNSPDs in a refrigerator and that allows reducing the number of cables while maintaining a high readout rate. In addition, the number of SNSPDs that can be mounted in a single refrigerator depends on the cooling capacity of the refrigerator and the power consumption of the multichannel SNSPD system. Therefore, to implement a highly scalable multichannel SNSPD system, it is necessary to develop a multi-readout scheme with excellent power-saving performance.

Against this background, the present disclosers have proposed a signal processing circuit including a superconducting single-flux-quantum (SFQ) device or a superconducting quantum interference device (hereinafter "SQUID") for reading out signals from a multi-pixel SNSPD array using fewer transmission cables than the number of SNSPDs (see Patent Literatures 1 to 5, for example).

### Citation List

### Patent Literature

PTL 1: Japanese Patent No. 5419122
PTL 2: Japanese Patent No. 5846626
PTL 3: Japanese Patent No. 5875045
PTL 4: Japanese Patent No. 6598302
PTL 5: WO 2020/179554 A1

### Summary of Invention

### Technical Problem

An exemplary object of the present disclosure is to propose a signal processing circuit and a signal processing method that can more appropriately process voltage signals generated by a current source and a SQUID than conventional circuits and methods.

### Solution to Problem

A signal processing circuit according to one aspect of the present disclosure includes: a first transmission line through which a pulse signal is transmitted, wherein a fall time taken for the pulse signal to fall from a peak value to a given level is longer than a rise time taken for the pulse signal to rise from the given level to the peak value; a SQUID including first and second magnetic field receivers that are magnetically coupled to the first transmission line in response to transmission of the pulse signal through the first transmission line; a second transmission line connected to a current source and the SQUID; and a first delay circuit disposed in the first transmission line to delay the pulse signal, the first delay circuit being located between a part of the first transmission line that is magnetically coupled to the first magnetic field receiver and a part of the first transmission line that is magnetically coupled to the second magnetic field receiver, wherein a delay time set for the pulse signal by the first delay circuit is shorter than a sum of the rise time and the fall time, and a magnetic field input to the first magnetic field receiver and a magnetic field input to the second magnetic field receiver are oriented in opposite directions such that a voltage signal transmitted through the second transmission line has a pulse width equal to the delay time.

A signal processing method according to one aspect of the present disclosure includes the steps of: transmitting a pulse signal through a first transmission line, wherein a fall time taken for the pulse signal to fall from a peak value to a given level is longer than a rise time taken for the pulse signal to rise from the given level to the peak value; magnetically coupling first and second magnetic field receivers of a SQUID to the first transmission line in response to transmission of the pulse signal through the first transmission line; delaying the pulse signal by a delay time shorter than a sum of the rise time and the fall time using a delay circuit located between a part of the first transmission line that is magnetically coupled to the first magnetic field receiver and a part of the first transmission line that is magnetically coupled to the second magnetic field receiver; and when a voltage signal is transmitted through a second transmission line connected to a current source and the SQUID in response to the magnetic coupling, shaping a waveform of the voltage signal such that the voltage signal has a pulse width equal to the delay time, wherein the shaping of the waveform is accomplished by orienting a magnetic field input to the first magnetic field receiver and a magnetic field input to the second magnetic field receiver in opposite directions.

### Advantageous Effects of Invention

A signal processing circuit and a signal processing method according to one aspect of the present disclosure have the advantage of more appropriately processing voltage signals generated by a current source and a SQUID than conventional circuits and methods.

### Brief Description of Drawings

FIG. 1A shows an example of conventional signal processing circuits.
FIG. 1B shows an example of a pulse signal output from an SNSPD.
FIG. 2A shows an example of a signal processing circuit according to a first embodiment.
FIG. 2B shows an example of a timing chart depicting a signal processed by the signal processing circuit of FIG. 2A.
FIG. 3 shows an example of simulation results verifying that the waveform of a voltage signal can be appropriately shaped by canceling magnetic fields input to a SQUID.
FIG. 4A shows an example of a signal processing circuit according to a second embodiment.
FIG. 4B shows an example of a timing chart depicting a signal processed by the signal processing circuit of FIG. 4A.
FIG. 5A shows an example of a signal processing circuit according to a variant of the second embodiment.
FIG. 5B shows an example of a timing chart depicting a signal processed by the signal processing circuit of FIG. 5A.

### Description of Embodiments

In recent years, attempts have been undertaken to put quantum networks and quantum internet service into practice. It is expected that the number of photon detectors required for one node in a quantum network or quantum internet service will increase. Demand for photon detectors is growing as competition in research and development for quantum computers intensifies. Scaling up a quantum computer is expected to entail an increase in the number of photon detectors required.

The present disclosers have proposed a signal processing circuit for a multi-pixel SNSPD array including a plurality of SNSPD light receivers (for example, Patent Literature 5). The proposed circuit is a multi-readout circuit using a SQUID (hereinafter "SQUID multiplexing circuit"). The SQUID multiplexing circuit is characterized in that it operates with low power consumption and that the power consumption is independent of the number of pixels in the SNSPDs. Accordingly, the SQUID multiplexing circuit offers excellent scalability with respect to the number of pixels in the SNSPDs.

However, the SQUID multiplexing circuit is disadvantageous in that when multiple pixels output signals simultaneously, the circuit cannot read out all of the signals at once. For example, in the case where the SQUID multiplexing circuit is used as a signal circuit for a multichannel SNSPD system, the signal output from an SNSPD in which photodetection has occurred needs to be completed before the signal from another SNSPD can be read out. This imposes a limitation on increasing the signal readout rate. The details will now be described.

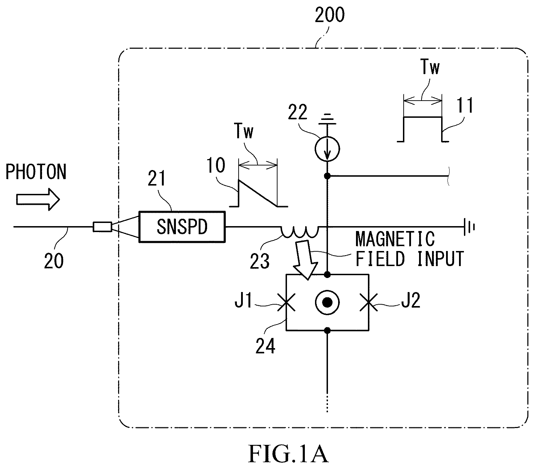

As shown in FIG. 1A, a SQUID 24 is mounted in a refrigerator 200 together with an SNSPD 21. Thus, the SQUID 24 is cooled to an extremely low temperature (around 2.3 Kelvin (K)). The SQUID 24 includes a pair of Josephson junctions J1 and J2, and functions to receive a magnetic field from an inductor 23 and convert a pulse signal 10 (current pulse) output from the SNSPD 21 into a voltage signal 11 having a square waveform. The details of the function of the SQUID 24 will be described later.

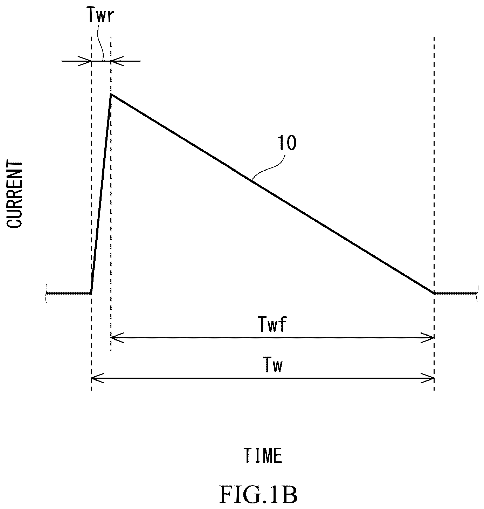

Generally, for the pulse signal 10 output from the SNSPD 21, a fall time Twf taken for the signal to fall from a peak value to a given level is longer than a rise time Twr taken for the signal to rise from the given level to the peak value. This relationship is shown in FIG. 1B. The pulse width Tw of the pulse signal 10 corresponds to the sum of the rise time Twr and the fall time Twf (Twr + twf) of the pulse signal 10.

The rise time Twr of the pulse signal 10 output from the SNSPD 21 is, for example, on the order of several picoseconds (ps) to several tens of picoseconds, whereas the fall time Twf of the pulse signal 10 is on the order of several tens of nanoseconds (ns). The SNSPD 21 exhibits high temporal resolution due to the steep rise characteristics of the pulse signal 10.

The fall characteristics of the pulse signal 10 depend on the inductance component (L) of the SNSPD 21. Thus, the fall time Twf of the pulse signal 10 corresponds to the dead time during which the SNSPD 21 cannot detect the next photon.

An existing SQUID multiplexing circuit exhibits sensitivity even during the fall time Twf of the pulse signal 10. Accordingly, as shown in FIG. 1A, the pulse width Tw of the pulse signal 10 and the pulse width Tw of the voltage signal 11 are approximately equal. Thus, when multiple SNSPDs 21 detect photons simultaneously, the waveforms of the voltage signals 11 overlap one another. As a result, temporal information related to photon incidence, which is based on the steep rise characteristics of the pulse signals 10, is lost. If a delay structure is provided to prevent the multiple SNSPDs 21 from detecting photons simultaneously and to read out the pulse signals 10 one by one, the rate at which the voltage signals 11 are read out decreases.

As a result of intensive studies, the present disclosers have found that the conventional problems can be addressed by canceling magnetic fields input to the SQUID, and have arrived at the following aspects of the present disclosure.

Specifically, a signal processing circuit according to a first aspect of the present disclosure includes: a first transmission line through which a pulse signal is transmitted, wherein a fall time taken for the pulse signal to fall from a peak value to a given level is longer than a rise time taken for the pulse signal to rise from the given level to the peak value; a SQUID including first and second magnetic field receivers that are magnetically coupled to the first transmission line in response to transmission of the pulse signal through the first transmission line; a second transmission line connected to a current source and the SQUID; and a first delay circuit disposed in the first transmission line to delay the pulse signal, the first delay circuit being located between a part of the first transmission line that is magnetically coupled to the first magnetic field receiver and a part of the first transmission line that is magnetically coupled to the second magnetic field receiver, wherein a delay time set for the pulse signal by the first delay circuit is shorter than a sum of the rise time and the fall time of the pulse signal, and a magnetic field input to the first magnetic field receiver and a magnetic field input to the second magnetic field receiver are oriented in opposite directions such that a voltage signal transmitted through the second transmission line has a pulse width equal to the delay time set for the pulse signal by the first delay circuit.

With this configuration, the signal processing circuit of the present aspect can more appropriately process voltage signals generated by the current source and the SQUID than conventional circuits. In the present disclosure, the statement that "a voltage signal transmitted through the second transmission line has a pulse width equal to the delay time set for the pulse signal by the first delay circuit" is intended to encompass both the case where the pulse width is exactly equal to the delay time and the case where the pulse width and the delay time are not exactly equal for various reasons but the same advantage is achieved. The difference between the pulse width and the delay time is preferably 100 picoseconds or less and more preferably several tens of picoseconds or less.

A signal processing circuit according to a second aspect of the present disclosure includes the features of the signal processing circuit of the first aspect, wherein the pulse signal may be a current signal detected by an SNSPD.

As stated above and as shown in FIG. 1B, the pulse signal output from the SNSPD rises over a period of about several tens of nanoseconds. During the fall time Twf of the pulse signal, the SQUID continues to receive the magnetic field inputs. Thus, in the case of an existing signal processing circuit as shown in FIG. 1A, the pulse width Tw of the voltage signal 11 generated by the current source 22 and the SQUID 24 is on the order of several tens of nanoseconds.

In contrast, the signal processing circuit of the present aspect is characterized in that the waveform of the voltage signal generated by the current source and the SQUID is appropriately shaped by the function of the delay circuit which delays the pulse signal output from the SNSPD and by the cancellation of the magnetic fields in the SQUID.

Specifically, in the signal processing circuit of the present aspect, once the SNSPD detects a photon, a magnetic field formed by the pulse signal output from the SNSPD is input to the first magnetic field receiver of the SQUID, causing the voltage signal to rise steeply. In addition, a magnetic field formed by the pulse signal delayed by the delay circuit is input to the second magnetic field receiver of the SQUID. Since the magnetic fields input to the first and second magnetic field receivers are oriented in opposite directions, the magnetic fields input to the SQUID are canceled. As a result, the SQUID quickly loses sensitivity to the pulse signal output from the SNSPD, so that the pulse width of the voltage signal becomes shorter than in cases where the magnetic fields input to the SQUID are not canceled.

Thanks to this shaping of the waveform of the voltage signal, the signal processing circuit of the present aspect can reduce the influence of the dead time during which the SNSPD cannot detect the next photon, compared to conventional circuits.

Furthermore, in the signal processing circuit of the present aspect, if the photon incidence timing temporally fluctuates for some reason, this fluctuation is appropriately reflected in the rise time of the pulse signal output from the SNSPD. The timing of rise of the voltage signal generated by the current source and the SQUID corresponds to the rise time of the pulse signal output from the SNSPD. Accordingly, the fluctuation is appropriately reflected in the rise time of the voltage signal, allowing the voltage signal to preserve temporal information related to photon incidence.

Furthermore, in the signal processing circuit of the present aspect, where the pulse width of the voltage signal generated by the current source and the SQUID is equal to the delay time set for the pulse signal by the first delay circuit, the pulse width of the voltage signal can be easily and appropriately set using the signal delay time which is a design parameter of the first delay circuit.

A signal processing circuit according to a third aspect of the present disclosure includes the features of the signal processing circuit of the first or second aspect and may include: a plurality of the first transmission lines; a plurality of the SNSPDs each of which is connected to a corresponding one of the first transmission lines; a plurality of the SQUIDs each of which is magnetically coupled to a corresponding one of the first transmission lines; a plurality of optical transmission lines through each of which photons emitted from a corresponding one of a plurality of light sources are transmitted to a corresponding one of the SNSPDs; and a delay structure that adjusts a time difference between an output timing of the voltage signal corresponding to one of the SQUIDs and an output timing of the voltage signal corresponding to another of the SQUIDs, the delay structure being configured to make the time difference longer than the delay time set for the pulse signal by the first delay circuit, wherein the SQUIDs may be connected in series in the second transmission line.

With this configuration, in the signal processing circuit of the present aspect, the time difference between the output timing of the voltage signal corresponding to the one of the SQUIDs and the output timing of the voltage signal corresponding to the other of the SQUIDs is longer than the delay time set for the pulse signal by the first delay circuit. Accordingly, the voltage signals can be appropriately multiplexed in the single second transmission line while preserving temporal information related to the incidence of photons emitted to the SNSPDs from the corresponding light sources.

Furthermore, in the signal processing circuit of the present aspect, where the time difference between the output timing of the voltage signal corresponding to the one of the SQUIDs and the output timing of the voltage signal corresponding to the other of the SQUIDs is longer than the delay time set for the pulse signal by the first delay circuit, the voltage signals can preserve positional information indicating on which of the SNSPDs the photons emitted from the light sources were incident.

Furthermore, in the signal processing circuit of the present aspect, the SQUIDs are connected in series in the second transmission line. Thus, the current from the current source remains constant regardless of the number of SNSPD channels. Accordingly, the signal processing circuit of the present aspect can operate with constant power consumption even when the number of SNSPD channels is increased. This makes the circuit highly scalable. In addition, in the signal processing circuit of the present aspect, the voltage signals generated by the SQUIDs corresponding respectively to the multichannel SNSPDs are less affected by variations in characteristics among the SNSPDs, and the pulse widths of the voltage signals can be kept constant.

A signal processing circuit according to a fourth aspect of present disclosure includes the features of the signal processing circuit of the third aspect, wherein the delay structure may be located in at least one of the optical transmission lines and include an optical fiber that delays photons transmitted through the optical transmission line.

With this configuration, in the signal processing circuit of the present aspect, the time difference between the output timing of the voltage signal corresponding to the one of the SQUIDs and the output timing of the voltage signal corresponding to the other of the SQUIDs can be easily and appropriately set using the photon delay time which is adjusted according to the optical fiber cable lengths in the optical transmission lines.

A signal processing circuit according to a fifth aspect of the present disclosure includes the features of the signal processing circuit of the third aspect, wherein the delay structure may include a second delay circuit that is located between the SQUIDs adjacent to each other in the second transmission line and that delays signals transmitted through the second transmission line.

With this configuration, in the signal processing circuit of the present aspect, the time difference between the output timing of the voltage signal corresponding to the one of the SQUIDs and the output timing of the voltage signal corresponding to the other of the SQUIDs can be easily and appropriately set using the signal delay time which is a design parameter of the second delay circuit located between the SQUIDs in the second transmission line.

A signal processing method according to a sixth aspect of the present disclosure includes the steps of: transmitting a pulse signal through a first transmission line, wherein a fall time taken for the pulse signal to fall from a peak value to a given level is longer than a rise time taken for the pulse signal to rise from the given level to the peak value; magnetically coupling first and second magnetic field receivers of a SQUID to the first transmission line in response to transmission of the pulse signal through the first transmission line; delaying the pulse signal by a delay time shorter than a sum of the rise time and the fall time using a delay circuit located between a part of the first transmission line that is magnetically coupled to the first magnetic field receiver and a part of the first transmission line that is magnetically coupled to the second magnetic field receiver; and
when a voltage signal is transmitted through a second transmission line connected to a current source and the SQUID in response to the magnetic coupling, shaping a waveform of the voltage signal such that the voltage signal has a pulse width equal to the delay time, wherein the shaping of the waveform is accomplished by orienting a magnetic field input to the first magnetic field receiver and a magnetic field input to the second magnetic field receiver in opposite directions.

Through these steps, the signal processing method of the present aspect can more appropriately process voltage signals generated by the current source and the SQUID than conventional methods. The details of the advantages offered by the signal processing method of the present aspect are the same as those of the advantages offered by the signal processing circuit of the first aspect and will therefore not be described below.

Hereinafter, specific examples of the various aspects of the present disclosure will be described with reference to the accompanying drawings. All of the specific examples described below are illustrative of the above aspects. Although shapes, materials, numerical values, constituent elements, the positions of the constituent elements, and the manner of connection between the constituent elements are mentioned below, they are not intended to limit the above aspects unless recited in the claims. The constituent elements described below include those that are not recited in the independent claims which define the broadest concept of the above aspects, and such constituent elements are described as optional elements. Some constituent elements are denoted by the same reference signs throughout the drawings, and repeated description of such constituent elements may be omitted. In the drawings, the constituent elements are schematically depicted for ease of understanding, and the shapes and the dimensional ratios of the depicted constituent elements may differ from those of actual structures.

### (First Embodiment)

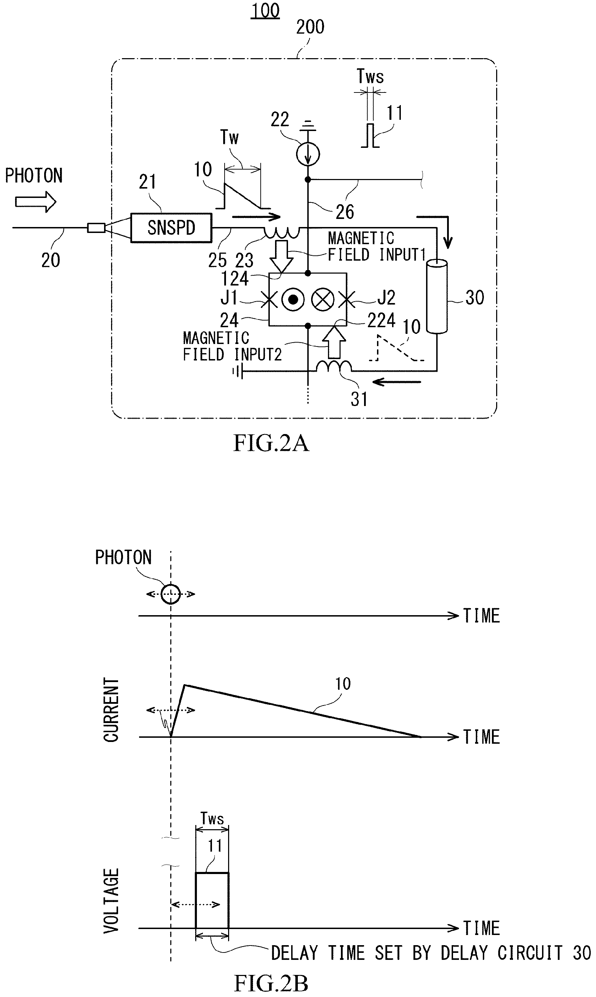

FIG. 2A shows an example of a signal processing circuit according to a first embodiment. FIG. 2B shows an example of a timing chart depicting a signal processed by the signal processing circuit of FIG. 2A.

In the example of FIG. 2A, a signal processing circuit 100 includes an SNSPD 21, a SQUID 24, a delay circuit 30, and a current source 22.

The SNSPD 21 is configured to detect photons coming through an optical transmission line 20 one by one. Upon detection of a photon by the SNSPD 21, a pulse current signal (hereinafter "pulse signal 10") is generated in a transmission line 25. As shown in FIG. 1B, the fall time Twf taken for the signal to fall from a peak value to a given level is longer than the rise time Twr taken for the signal to rise from the given level to the peak value. For example, the rise time Twr of the pulse signal 10 is on the order of several picoseconds to several tens of picoseconds, whereas the fall time Twf of the pulse signal 10 is on the order of several tens of nanoseconds. In this case, where the rise time Twr of the pulse signal 10 is so short relative to the fall time Twf of the pulse signal 10 as to be negligible, the pulse width Tw of the pulse signal 10 is approximately equal to the fall time Twf.

The configuration and operation of the SNSPD 21 described above are well known and will therefore not be described in detail herein.

The optical transmission line 20 is a line through which photons emitted from an unillustrated light source are transmitted. The transmission line 25 is a line through which the pulse signal 10 is transmitted. The optical transmission line 20 and the transmission line 25 may be implemented in any configurations, provided that the photons and the pulse signal 10 can be transmitted. The optical transmission line 20 may be configured, for example, as an optical fiber line. The transmission line 25 may be configured as a wiring pattern.

As previously stated, the SQUID 24 functions to convert the pulse signal 10 output from the SNSPD 21 into a voltage signal 11 having a square waveform.

A bias current is supplied from the current source 22 to the SQUID 24. The SQUID 24 is mounted in the refrigerator 200 together with the SNSPD 21, so that the SNSPD 21 and the SQUID 24 are in a superconducting state.

When the pulse signal 10 is transmitted through the transmission line 25, the SQUID 24 receives a magnetic field input via an inductor 23. As shown in FIG. 2A, the SQUID 24 includes a pair of Josephson junctions J1 and J2. The current in the SQUID 24 is biased by the current source 22 to a level below the critical current. Accordingly, in the absence of the magnetic field input, the voltage generated between the terminals of the SQUID 24 is 0 V. Once the pulse signal reaches the inductor 23, a magnetic field is input to the SQUID 24, reducing the critical current of the SQUID 24 to a value equal to or below the bias current. As a result, a potential difference is generated between the terminals of the SQUID 24.

In the signal processing circuit 100 of the present embodiment, the SQUID 24 includes first and second magnetic field receivers 124 and 224 that are magnetically coupled to the transmission line 25 in response to transmission of the pulse signal 10 output from the SNSPD 21 through the transmission line 25. Each of the first and second magnetic field receivers 124 and 224 may include an unillustrated inductor. That is, when the pulse signal 10 is transmitted through the transmission line 25, magnetic fields are input to the first and second magnetic field receivers 124 and 224 of the SQUID 24 via the inductors 23 and 31, respectively.

The delay circuit 30 is disposed in the transmission line 25 to delay the pulse signal. The delay circuit 30 is located between the inductor 23 constituting a part of the transmission line 25 that is magnetically coupled to the first magnetic field receiver 124 and the inductor 31 constituting a part of the transmission line 25 that is magnetically coupled to the second magnetic field receiver 224.

Specifically, before the pulse signal 10 (solid line) transmitted through the transmission line 25 passes through the delay circuit 30, a pulse current flows through the inductor 23, generating a magnetic field. The first magnetic field receiver 124 receives the magnetic field, which is input to the SQUID 24. After the pulse signal 10 (dashed line) transmitted through the transmission line 25 passes through the delay circuit 30, a pulse current flows through the inductor 31, generating a magnetic field. The second magnetic field receiver 224 receives the magnetic field, which is input to the SQUID 24.

The delay circuit 30 may be implemented in any configuration, provided that the delay circuit 30 can delay the pulse signal transmitted through the transmission line 25 by a predetermined amount of delay time. For example, the delay circuit 30 may be formed by shaping the wiring pattern of the transmission line 25 into a meandering configuration.

In the signal processing circuit 100 of the present embodiment, the delay time set for the pulse signal 10 by the delay circuit 30 is shorter than the sum of the rise time Twr and the fall time Twf (Twr + Twf) of the pulse signal 10. In other words, the delay circuit 30 delays the pulse signal 10 by a delay time shorter than the sum of the rise time Twr and the fall time Twf (Twr + Twf) of the pulse signal 10. In an actual circuit, the delay time set for the pulse signal 10 by the delay circuit 30 is a desired value of greater than zero that is determined according to various parameters. The delay time may be longer or shorter than the rise time Twr of the pulse signal 10.

Furthermore, in the signal processing circuit 100 of the present embodiment, the direction of the magnetic field input to the first magnetic field receiver 124 (magnetic field input 1) and the direction of the magnetic field input to the second magnetic field receiver 224 (magnetic field input 2) are opposite to each other as shown in FIG. 2A. Specifically, the wiring pattern of the transmission line 25 is formed such that the current passing through the inductor 23 and the current passing through the inductor 31 flow in opposite directions. Consequently, the magnetic fields at the magnetic field inputs 1 and 2 can be oriented in opposite directions. With this feature, the SQUID 24 quickly loses sensitivity to the pulse signal 10 output from the SNSPD 21, so that the pulse width Tws of the voltage signal 11 transmitted through a transmission line 26 becomes equal to the delay time set for the pulse signal 10 by the delay circuit 30. That is, when the voltage signal 11 is transmitted through the transmission line 26 in response to the magnetic coupling, the magnetic field input to the first magnetic field receiver 124 and the magnetic field input to the second magnetic field receiver 224 are oriented in opposite directions. Consequently, the waveform of the voltage signal 11 is shaped such that, as shown in FIG. 2B, the pulse width Tws of the voltage signal 11 is equal to the delay time.

### <Verification by Simulation>

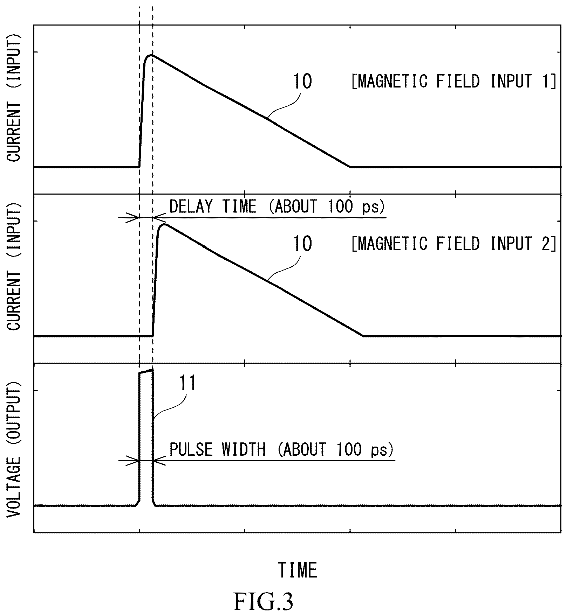

FIG. 3 shows an example of simulation results verifying that the waveform of the voltage signal can be appropriately shaped by canceling the magnetic fields input to the SQUID.

In this simulation, a Josephson circuit simulator JSIM was used to reproduce the signal processing circuit 100 of FIG. 2A on a computer. The peak current of the pulse signal 10 transmitted through the transmission line 25 was 20 µA, and the delay time set for the pulse signal 10 by the delay circuit 30 was 100 picoseconds.

As seen from FIG. 3, the simulation verified that canceling the magnetic fields input to the SQUID 24, namely the magnetic fields at the magnetic field inputs 1 and 2, resulted in a voltage signal having a pulse width of about 100 picoseconds which is substantially equal to the delay time.

As described above, the signal processing circuit 100 of the present embodiment, which is shown in FIG. 2A, and the signal processing method of the present embodiment, can more appropriately process the voltage signal 11 generated by the current source 22 and the SQUID 24 than conventional circuits and methods.

As previously stated and as shown in FIG. 1B, the pulse signal 10 output from the SNSPD 21 rises over a period of about several tens of nanoseconds. During the fall time Twf of the pulse signal 10, the SQUID 21 continues to receive the magnetic field inputs. Thus, in the case of an existing signal processing circuit as shown in FIG. 1A, the pulse width of the voltage signal 11 generated by the current source 22 and the SQUID 24 is on the order of several tens of nanoseconds.

In contrast, the signal processing circuit 100 and the signal processing method of the present embodiment are characterized in that the waveform of the voltage signal 11 generated by the current source 22 and the SQUID 24 is appropriately shaped by the function of the delay circuit 30 which delays the pulse signal 10 output from the SNSPD 21 and by the cancellation of the magnetic fields in the SQUID 24.

Specifically, in the signal processing circuit 100 and the signal processing method of the present embodiment, once the SNSPD 21 detects a photon, a magnetic field formed by the pulse signal output from the SNSPD 21 is input to the first magnetic field receiver 124 of the SQUID 24, causing the voltage signal 11 to rise steeply. In addition, a magnetic field formed by the pulse signal 10 delayed by the delay circuit 30 is input to the second magnetic field receiver 224 of the SQUID 24. Since the magnetic fields input to the first and second magnetic field receivers 124 and 224 are oriented in opposite directions, the magnetic fields input to the SQUID 24 are canceled. As a result, the SQUID 24 quickly loses sensitivity to the pulse signal 10 output from the SNSPD 21, so that the pulse width Tws of the voltage signal 11 becomes shorter than in cases where the magnetic fields input to the SQUID 24 are not canceled.

Thanks to this shaping of the waveform of the voltage signal 11, the signal processing circuit 100 and the signal processing method of the present embodiment can reduce the influence of the dead time during which the SNSPD 21 cannot detect the next photon, compared to conventional circuits and methods.

The following discussion addresses temporal fluctuations in the photon incidence timing in the signal processing circuit 100 and the signal processing method of the present embodiment. The dotted arrows in FIG. 2B represent temporal fluctuations in the timing at which photons are incident on the SNSPD 21. If the photon incidence timing temporally fluctuates for some reason, this fluctuation is appropriately reflected in the rise time of the pulse signal 10 output from the SNSPD 21. The timing of rise of the voltage signal 11 generated by the current source 22 and the SQUID 24 corresponds to the rise time of the pulse signal 10 output from the SNSPD 21. Accordingly, the fluctuation is appropriately reflected in the rise time of the voltage signal 11, allowing the voltage signal 11 to preserve temporal information related to photon incidence.

Furthermore, in the signal processing circuit 100 and the signal processing method of the present embodiment, where the pulse width Tws of the voltage signal 11 generated by the current source 22 and the SQUID 24 is equal to the delay time set for the pulse signal by the delay circuit 30, the pulse width Tws of the voltage signal 11 can be easily and appropriately set using the signal delay time which is a design parameter of the delay circuit 30.

### (Second Embodiment)

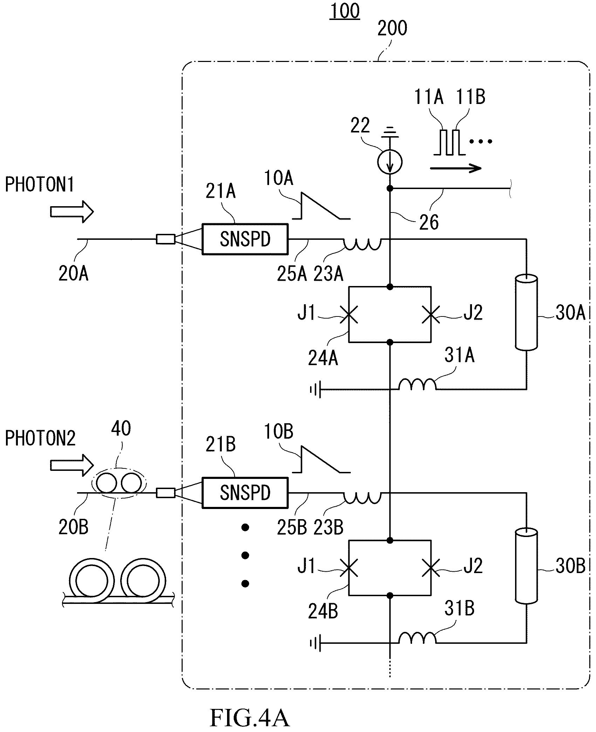

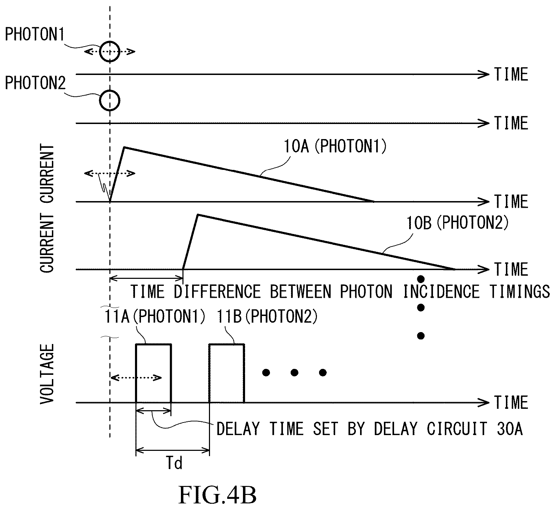

FIG. 4A shows an example of a signal processing circuit according to a second embodiment. FIG. 4B shows an example of a timing chart depicting a signal processed by the signal processing circuit of FIG. 4A.

In the example of FIG. 4A, the signal processing circuit 100 includes a plurality of SNSPDs 21A and 21B, a plurality of SQUIDs 24A and 24B, a plurality of delay circuits 30A and 30B, a single current source 22, and a delay structure 40. The SQUIDs 24A and 24B are connected in series in a transmission line 26 extending from the current source 22.

FIG. 4A shows the configuration of the signal processing circuit 100 in which the numbers of SNSPDs 21A and 21B and SQUIDs 24A and 24B are two. The numbers of SNSPDs and SQUIDs may be any values. For example, several hundred SNSPDs and several hundred SQUIDs may be arranged in the signal processing circuit 100.

Each of the SNSPDs 21A and 21B is a detector connected to a corresponding one of the transmission lines 25A and 25B. A pulse signal 10A output from the SNSPD 21A is transmitted through the transmission line 25A. A pulse signal 10B output from the SNSPD 21B is transmitted through the transmission line 25B. The SQUID 24A is a device that is magnetically coupled to inductors 23A and 31A each of which constitutes a part of the transmission line 25A. The SQUID 24B is a device that is magnetically coupled to inductors 23B and 31B each of which constitutes a part of the transmission line 25B. Each of the optical transmission lines 20A and 20B is an optical path through which photons emitted from a corresponding one of unillustrated light sources are transmitted to a corresponding one of the SNSPDs 21A and 21B. In other words, in the present embodiment, the light sources and the SNSPDs 21A and 21B are arranged in one-to-one correspondence, and each pair of light source and SNSPD operates independently.

The delay structure 40 adjusts a time difference Td (see FIG. 4B) between the output timing of a voltage signal 11A corresponding to the SQUID 24A and the output timing of a voltage signal 11B corresponding to the SQUID 24B. Specifically, the delay structure 40 makes the time difference Td longer than the delay time (see FIG. 4B) set for the pulse signal 10 by the delay circuit 30A. For example, the time difference Td between the output timings of the voltage signals 11A and 11B may be about twice the delay time set for the pulse signal 10. In other words, the time difference Td between the output timings of the voltage signals 11A and 11B may be about twice the pulse width Tws of the voltage signals 11 transmitted through the transmission line 26.

The configurations of the SNSPDs 21A and 21B, the transmission lines 25A and 25B, the SQUIDs 24A and 24B, the inductors 23A, 31A, 23B, and 31B, the optical transmission lines 20A and 20B, and the delay circuits 30A and 30B will not be described in detail below as these components have the same configurations as in the first embodiment, except that their respective numbers differ.

In the example of FIG. 4A, the delay structure 40 is located in the optical transmission line 20B and includes an optical fiber that delays photons transmitted through the optical transmission line 20B.

The delay structure 40 may be implemented in any configuration, provided that the delay structure 40 can delay photons transmitted through the optical transmission line 20B. For example, the optical fiber cable length may differ between the optical transmission lines 20A and 20B. By providing the difference in cable length, the incidence timings at which photons reach the SNSPDs 21A and 21B can be adjusted as appropriate. For example, as shown in FIG. 4A, the optical fiber cable in the optical transmission line 20B may include two loop portions. In contrast, the optical fiber cable in the optical transmission line 20A does not include such loop portions. In this configuration, where the optical transmission lines 20A and 20B have different cable lengths, the timings at which photons are incident on the SNSPDs 21A and 21B can be easily adjusted depending on the optical fiber cable lengths, as shown in FIG. 4B. In the signal processing circuit 100 of the present embodiment, the time difference between the timings at which photons are incident on the SNSPDs 21A and 21B corresponds to the time difference Td between the output timings of the voltage signals 11A and 11B.

The above-mentioned number of loop portions is merely illustrative and not limiting. In the signal processing circuit 100, the number of loop portions may be set as appropriate to achieve a desired time difference Td between the output timings of the voltage signals 11A and 11B.

As described above, in the signal processing circuit 100 of the present embodiment, the time difference Td between the output timings of the voltage signals 11A and 11B corresponding respectively to the SQUIDs 24A and 24B is longer than the delay time set for the pulse signal 10 by the delay circuit 30A. Accordingly, as shown in FIG. 4B, the voltage signals 11A and 11B can be appropriately multiplexed in the single transmission line 26 while preserving temporal information related to the incidence of photons emitted to the SNSPDs 21A and 21B from the corresponding light sources.

Furthermore, in the signal processing circuit 100 of the present embodiment, where the time difference Td between the output timings of the voltage signals 11A and 11B corresponding respectively to the SQUIDs 24A and 24B is longer than the delay time set for the pulse signal 10 by the delay circuit 30A, the voltage signals 11A and 11B can preserve positional information indicating on which of the SNSPDs 24A and 24B the photons emitted from the light sources were incident.

Furthermore, in the signal processing circuit 100 of the present embodiment, the SQUIDs 24A and 24B are connected in series in the transmission line 26. Thus, the current from the current source 22 remains constant regardless of the number of SNSPD channels. Accordingly, the signal processing circuit 100 of the present embodiment can operate with constant power consumption even when the number of SNSPD channels is increased. This makes the circuit highly scalable. In addition, in the signal processing circuit 100 of the present embodiment, the voltage signals generated by the SQUIDs corresponding respectively to the multichannel SNSPDs are less affected by variations in characteristics among the SNSPDs, and the pulse widths of the voltage signals can be kept constant.

Furthermore, in the signal processing circuit 100 of the present embodiment, the time difference Td between the output timings of the voltage signals 11A and 11B corresponding respectively to the SQUIDs 21A and 21B can be easily and appropriately set using the photon delay time which is adjusted according to the optical fiber cable lengths in the optical transmission lines 20.

The signal processing circuit 100 of the present embodiment may be the same as the signal processing circuit 100 of the first embodiment, except for the features described above.

### (Variants)

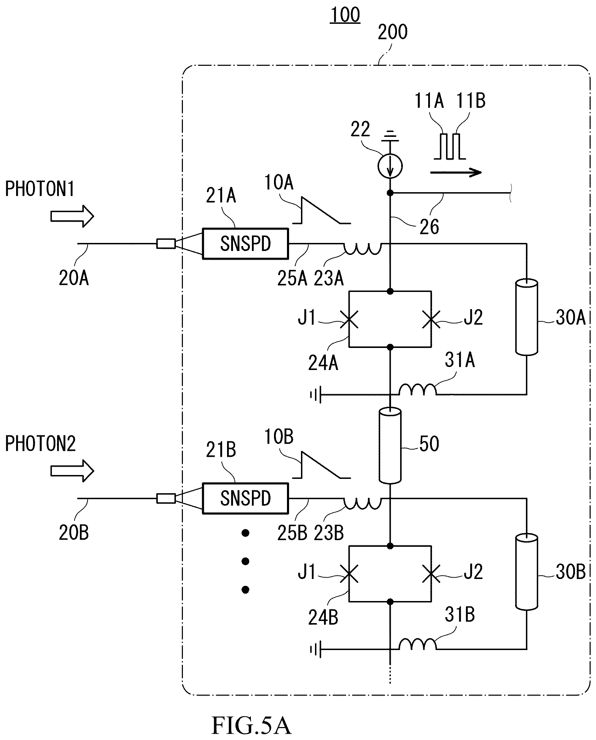

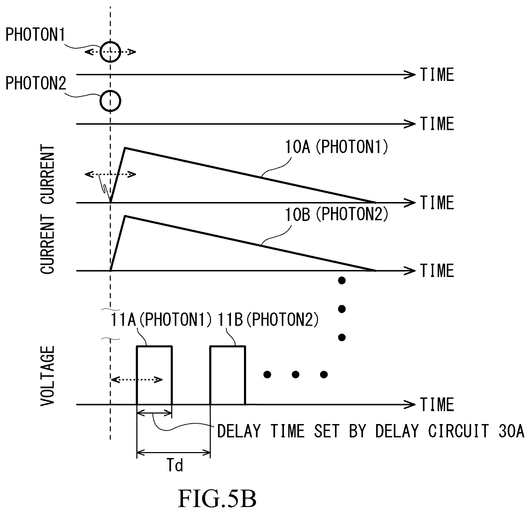

FIG. 5A shows an example of a signal processing circuit according to a variant of the second embodiment. FIG. 5B shows an example of a timing chart depicting a signal processed by the signal processing circuit of FIG. 5A.

In the example of FIG. 5A, the signal processing circuit 100 includes a plurality of SNSPDs 21A and 21B, a plurality of SQUIDs 24A and 24B, a plurality of delay circuits 30A and 30B, a single current source 22, and a delay structure 50. The SQUIDs 24A and 24B are connected in series in a transmission line 26 extending from the current source 22.

FIG. 5A shows the configuration of the signal processing circuit 100 in which the numbers of SNSPDs 21A and 21B and SQUIDs 24A and 24B are two. The numbers of SNSPDs and SQUIDs may be any values. For example, several hundred SNSPDs and several hundred SQUIDs may be arranged in the signal processing circuit 100.

Each of the SNSPDs 21A and 21B is a detector connected to a corresponding one of the transmission lines 25A and 25B. A pulse signal 10A output from the SNSPD 21A is transmitted through the transmission line 25A. A pulse signal 10B output from the SNSPD 21B is transmitted through the transmission line 25B. The SQUID 24A is a device that is magnetically coupled to inductors 23A and 31A each of which constitutes a part of the transmission line 25A. The SQUID 24B is a device that is magnetically coupled to inductors 23B and 31B each of which constitutes a part of the transmission line 25B. Each of the optical transmission lines 20A and 20B is an optical path through which photons emitted from a corresponding one of unillustrated light sources are transmitted to a corresponding one of the SNSPDs 21A and 21B. In other words, in the present embodiment, the light sources and the SNSPDs 21A and 21B are arranged in one-to-one correspondence, and each pair of light source and SNSPD operates independently.

The delay structure 50 adjusts a time difference Td (see FIG. 5B) between the output timing of a voltage signal 11A corresponding to the SQUID 24A and the output timing of a voltage signal 11B corresponding to the SQUID 24B. Specifically, the delay structure 50 makes the time difference Td longer than the delay time (see FIG. 5B) set for the pulse signal 10 by the delay circuit 30A. For example, the time difference Td between the output timings of the voltage signals 11A and 11B may be about twice the delay time set for the pulse signal 10. In other words, the time difference Td between the output timings of the voltage signals 11A and 11B may be about twice the pulse width Tws of the voltage signals 11 transmitted through the transmission line 26.

The configurations of the SNSPDs 21A and 21B, the transmission lines 25A and 25B, the SQUIDs 24A and 24B, the inductors 23A, 31A, 23B, and 31B, the optical transmission lines 20A and 20B, and the delay circuits 30A and 30B will not be described in detail below as these components have the same configurations as in the first embodiment, except that their respective numbers differ.

In the example of FIG. 5A, the delay structure 50 is a delay circuit that is located between the adjacent SQUIDs 24A and 24B in the transmission line 26 and that delays signals transmitted through the transmission line 26.

The delay structure 50 may be implemented in any configuration, provided that the delay structure 50 can delay signals transmitted through the transmission line 26. For example, the delay circuit may be formed by shaping the wiring pattern of the transmission line 26 into a meandering configuration. In the signal processing circuit 100 of the present variant, the signal delay time set by the delay circuit corresponds to the time difference Td between the output timings of the voltage signals 11A and 11B.

As described above, in the signal processing circuit 100 of the present variant, the time difference Td between the output timings of the voltage signals 11A and 11B corresponding respectively to the SQUIDs 24A and 24B is longer than the delay time set for the pulse signal 10 by the delay circuit 30A. Accordingly, as shown in FIG. 5B, the voltage signals 11A and 11B can be appropriately multiplexed in the single transmission line 26 while preserving temporal information related to the incidence of photons emitted to the SNSPDs 21A and 21B from the corresponding light sources.

Furthermore, in the signal processing circuit 100 of the present variant, where the time difference Td between the output timings of the voltage signals 11A and 11B corresponding respectively to the SQUIDs 24A and 24B is longer than the delay time set for the pulse signal 10 by the delay circuit 30A, the voltage signals 11A and 11B can preserve positional information indicating on which of the SNSPDs 21A and 21B the photons emitted from the light sources were incident.

Furthermore, in the signal processing circuit 100 of the present variant, the SQUIDs 24A and 24B are connected in series in the transmission line 26. Thus, the current from the current source 22 remains constant regardless of the number of SNSPD channels. Accordingly, the signal processing circuit 100 of the present variant can operate with constant power consumption even when the number of SNSPD channels is increased. This makes the circuit highly scalable. In addition, in the signal processing circuit 100 of the present variant, the voltage signals generated by the SQUIDs corresponding respectively to the multichannel SNSPDs are less affected by variations in characteristics among the SNSPDs, and the pulse widths of the voltage signals can be kept constant.

Furthermore, in the signal processing circuit 100 of the present variant, the time difference Td between the output timings of the voltage signals 11A and 11B corresponding respectively to the SQUIDs 24A and 24B can be easily and appropriately adjusted using the signal delay time which is a design parameter of the delay circuit located between the SQUIDs 24A and 24B in the transmission line 26.

The signal processing circuit 100 of the present variant may be the same as the signal processing circuit 100 of the first or second embodiment, except for the features described above.

The first embodiment, the second embodiment, and the variant of the second embodiment may be combined unless they conflict with each other. From the foregoing description, numerous modifications and other embodiments of the present disclosure are obvious to those skilled in the art. Accordingly, the foregoing description is to be construed as illustrative only, and is provided for the purpose of teaching those skilled in the art the best mode for carrying out the present disclosure. The structural and/or functional details may be substantially modified without departing from the scope of the present disclosure.

### Industrial Applicability

One aspect of the present disclosure is applicable to a signal processing circuit and a signal processing method that can more appropriately process voltage signals generated by a current source and a SQUID than conventional circuits and methods.

### Reference Signs List

10: pulse signal
11: voltage signal
11A: voltage signal
11B: voltage signal
20: optical transmission line
20A: optical transmission line
20B: optical transmission line
21: SNSPD
21A: SNSPD
21B: SNSPD
22: current source
23: inductor
23A: inductor
23B: inductor
24: SQUID
24A: SQUID
24B: SQUID
25: transmission line
25A: transmission line
25B: transmission line
26: transmission line
30: delay circuit
30A: delay circuit
30B: delay circuit
31: inductor
31A: inductor
31B: inductor
40: delay structure
50: delay structure
100: signal processing circuit
124: first magnetic field receiver
200: refrigerator
224: second magnetic field receiver
Td: time difference
Tw: pulse width
Twf: fall time
Twr: rise time
Tws: pulse width

## Claims

1. A signal processing circuit comprising:
a first transmission line through which a pulse signal is transmitted, wherein a fall time taken for the pulse signal to fall from a peak value to a given level is longer than a rise time taken for the pulse signal to rise from the given level to the peak value;
a superconducting quantum interference device including first and second magnetic field receivers that are magnetically coupled to the first transmission line in response to transmission of the pulse signal through the first transmission line;
a second transmission line connected to a current source and the superconducting quantum interference device; and
a first delay circuit disposed in the first transmission line to delay the pulse signal, the first delay circuit being located between a part of the first transmission line that is magnetically coupled to the first magnetic field receiver and a part of the first transmission line that is magnetically coupled to the second magnetic field receiver, wherein
a delay time set for the pulse signal by the first delay circuit is shorter than a sum of the rise time and the fall time, and
a magnetic field input to the first magnetic field receiver and a magnetic field input to the second magnetic field receiver are oriented in opposite directions such that a voltage signal transmitted through the second transmission line has a pulse width equal to the delay time.

2. The signal processing circuit according to claim 1, wherein the pulse signal is a current signal detected by a superconducting nanostrip single-photon detector.

3. The signal processing circuit according to claim 1 or 2, comprising:
a plurality of the first transmission lines;
a plurality of the superconducting nanostrip single-photon detectors each of which is connected to a corresponding one of the first transmission lines;
a plurality of the superconducting quantum interference devices each of which is magnetically coupled to a corresponding one of the first transmission lines;
a plurality of optical transmission lines through each of which photons emitted from a corresponding one of a plurality of light sources are transmitted to a corresponding one of the superconducting nanostrip single-photon detectors; and
a delay structure that adjusts a time difference between an output timing of the voltage signal corresponding to one of the superconducting quantum interference devices and an output timing of the voltage signal corresponding to another of the superconducting quantum interference devices, the delay structure being configured to make the time difference longer than the delay time, wherein
the superconducting quantum interference devices are connected in series in the second transmission line.

4. The signal processing circuit according to claim 3, wherein the delay structure is located in at least one of the optical transmission lines and includes an optical fiber that delays photons transmitted through the optical transmission line.

5. The signal processing circuit according to claim 3, wherein the delay structure includes a second delay circuit that is located between the superconducting quantum interference devices adjacent to each other in the second transmission line and that delays signals transmitted through the second transmission line.

6. A signal processing method comprising the steps of:
transmitting a pulse signal through a first transmission line, wherein a fall time taken for the pulse signal to fall from a peak value to a given level is longer than a rise time taken for the pulse signal to rise from the given level to the peak value;
magnetically coupling first and second magnetic field receivers of a superconducting quantum interference device to the first transmission line in response to transmission of the pulse signal through the first transmission line;
delaying the pulse signal by a delay time shorter than a sum of the rise time and the fall time using a delay circuit located between a part of the first transmission line that is magnetically coupled to the first magnetic field receiver and a part of the first transmission line that is magnetically coupled to the second magnetic field receiver; and
when a voltage signal is transmitted through a second transmission line connected to a current source and the superconducting quantum interference device in response to the magnetic coupling, shaping a waveform of the voltage signal such that the voltage signal has a pulse width equal to the delay time, wherein the shaping of the waveform is accomplished by orienting a magnetic field input to the first magnetic field receiver and a magnetic field input to the second magnetic field receiver in opposite directions.
